# EUROPÄISCHE PATENTANMELDUNG

(11) **EP 0 765 033 A2**
(43) Veröffentlichungstag der Anmeldung: **26.03.1997**
(21) Anmeldenummer: 96114181.9
(22) Anmeldetag: 04.09.1996
(51) Int. Cl.: H03K 5/135

(54) **Schaltungsanordnung zur Erzeugung eines Freigabesignals für eine taktsteuerbare Schaltung**

(30) Priorität: 19.09.1995 DE 19534785
(71) Anmelder: SIEMENS AKTIENGESELLSCHAFT, 80333 München (DE)
(72) Erfinder: Lewalter, Siegfried, 81927 München (DE)

(57) **Zusammenfassung**

Eine Schaltungsanordnung zur Erzeugung eines Freigabesignals für eine taktsteuerbare Schaltung enthält eine Einrichtung (7) zur Erzeugung eines Power-on-Reset-Signals (POR). Die Deaktivierung dieses Signals wird mittels einer Verzögerungseinrichtung (6, 9) zeitlich verzögert und zur Freigabe eines von einem Oszillator (1) abgegebenen Taktsignals (T) verwendet, durch das die Schaltung (30) taktweise gesteuert wird. Die Verzögerungszeit der Verzögerungseinrichtung (6, 9) wird vom Oszillator (1) über eine Pegelbewertungseinrichtung (5), vorzugsweise einen Schmitt-Trigger, gesteuert. Dadurch wird erreicht, daß das Taktsignal (T) erst dann freigegeben wird, wenn der Oszillator (1) mit stabiler Amplitude und bei Sollfrequenz schwingt.

## Beschreibung

Die Erfindung betrifft eine Schaltungsanordnung zur Erzeugung eines Freigabesignals für eine taktsteuerbare Schaltung mit einem Taktgenerator.

Taktgesteuerte Schaltungen, insbesondere Mikroprozessoren, werden von einem ein Referenztaktsignal bereitstellenden Taktgenerator gespeist. Der Taktgenerator ist üblicherweise ein Quarzoszillator. Bekanntlich dauert es relativ lange, bis der Quarzoszillator nach dem Einschalten der Versorgungsspannung angeschwungen ist und eine stabile Schwingfrequenz bei stabiler Schwingungsamplitude aufweist. In der deutschen Patentschrift DE-C1-39 40 745 ist eine Schaltungsanordnung beschrieben, bei der unmittelbar nach Anlegen der Versorgungsspannung für die Taktversorgung zuerst auf einen schnell anschwingenden RC-Oszillator geschaltet wird und dann bei eingeschwungenem Quarzoszillator auf diesen umgeschaltet wird. Die Umschaltung wird aufgrund eines Frequenzvergleichs oder aufgrund von dem Quarzoszillator nachgeschalteten Zählmitteln erreicht. Darüber hinaus ist beschrieben, den aktiven Zustand des Rücksetzsignals solange beizubehalten, bis der bereits angeschwungene Oszillator, d. h. der RC-Oszillator, eine bestimmte Mindestanzahl von Oszillatorperioden ausgeführt hat.

Nachteilig bei der bekannten Anordnung ist der erhöhte Schaltungsaufwand für den RC-Oszillator und für die Umschaltmittel zwischen RC- und Quarzoszillator.

Die Aufgabe der Erfindung besteht darin, eine Schaltungsanordnung zur Erzeugung eines Freigabesignals für eine taktsteuerbare Schaltung anzugeben, die mit weniger Schaltungsaufwand realisierbar ist und die das Freigabesignal sicher erst dann erzeugt, wenn der Oszillator eingeschwungen ist.

Erfindungsgemäß wird diese Aufgabe durch eine Schaltungsanordnung nach den Merkmalen des Patentanspruchs 1 gelöst.

Wesentlich bei der erfindungsgemäßen Schaltungsanordnung ist die Verwendung einer Pegelbewertungseinrichtung, durch die vom Taktgenerator abgegebene Schwingungssignale in bezug auf ihre Amplitude bewertet werden. Bis sich am Taktgeneratorausgang eine stabile, eingeschwungene Schwingung einstellt, liegt im wesentlichen ein Rauschsignal vor, das durch die Pegelbewertungseinrichtung wirksam unterdrückt wird. In der eingangs genannten Patentschrift DE-C1-39 40 745 wird das Zählen der Oszillatorperioden, während denen das Rücksetzsignal noch aktiv gehalten werden soll, nur im sicher eingeschwungenen Zustand eines der Oszillatoren durchgeführt. Dies erfordert im Vergleich zur Erfindung den oben beschriebenen höheren Schaltungsaufwand in Form eines zusätzlichen, schnell anschwingenden RC-Oszillators.

Zweckmäßigerweise wird durch die Pegelbewertungseinrichtung ein Vergleich des vom Taktgenerator abgegebenen Signals mit mindestens zwei Schwellwerten durchgeführt. In der praktischen Realisierung liegen die Schwellwerte möglichst symmetrisch zum Arbeitspunkt des Oszillators. Zur Pegelbewertung wird vorteilhafterweise ein Schmitt-Trigger verwendet.

Durch die vom Schmitt-Trigger gesteuerte Verzögerungseinrichtung wird ein Startimpuls, zweckmäßigerweise ein versorgungsspannungsabhängig erzeugter Impuls, verzögert. Dieser Impuls kann durch eine sogenannte Power-on-Reset-Schaltung erzeugt werden, die einen Impuls geeigneter Länge beim Ansteigen der Versorgungsspannung erzeugt. Ein Beispiel für eine Power-on-Reset-Schaltung ist beispielsweise in der US-Patentschrift US-A-4 300 065 beschrieben.

Die Verzögerungszeit, durch die eine Flanke des von der Power-on-Reset-Schaltung gelieferten Impulses verzögert wird, wird durch die Pegelbewertungseinrichtung derart beeinflußt, daß durch die von der Pegelbewertungseinrichtung abgegebenen Impulse ein Zähler hochgezählt wird, der bei Erreichen eines bestimmten Zählerstands, beispielsweise eines Überlaufs, ein Signal abgibt, durch das der bis dahin festgehaltene Power-on-Reset-Impuls beendet wird.

Das dadurch erzeugte Freigabesignal gibt an, daß sich der Oszillator mit stabiler Frequenz und stabiler Amplitude im eingeschwungenen Zustand befindet und der Betrieb der vom Taktgenerator taktgesteuerten Schaltung nunmehr sicher beginnen kann. Hierzu werden beispielsweise die Logikschaltungen der taktgesteuerten Schaltung, die bisher auf einen Anfangszustand zurückgesetzt (Reset) waren, freigegeben und/oder wird die im Takt zu steuernde Schaltung mit dem Taktgenerator verbunden und somit freigegeben. Durch den Zähler in Verbindung mit der Pegelbewertungsschaltung wird verhindert, daß bereits einzelne vom Oszillator abgegebene Störimpulse vor dem eingeschwungenen Zustand den Reset-Zustand beenden.

Nachfolgend wird die Erfindung anhand der in der Zeichnung dargestellten Figuren näher erläutert. Es zeigen:
- Figur 1: ein Schaltbild einer schaltungstechnischen Realisierung der erfindungsgemäßen Schaltung und
- Figur 2: ein Signaldiagramm von in Figur 1 vorkommenden Signalen.

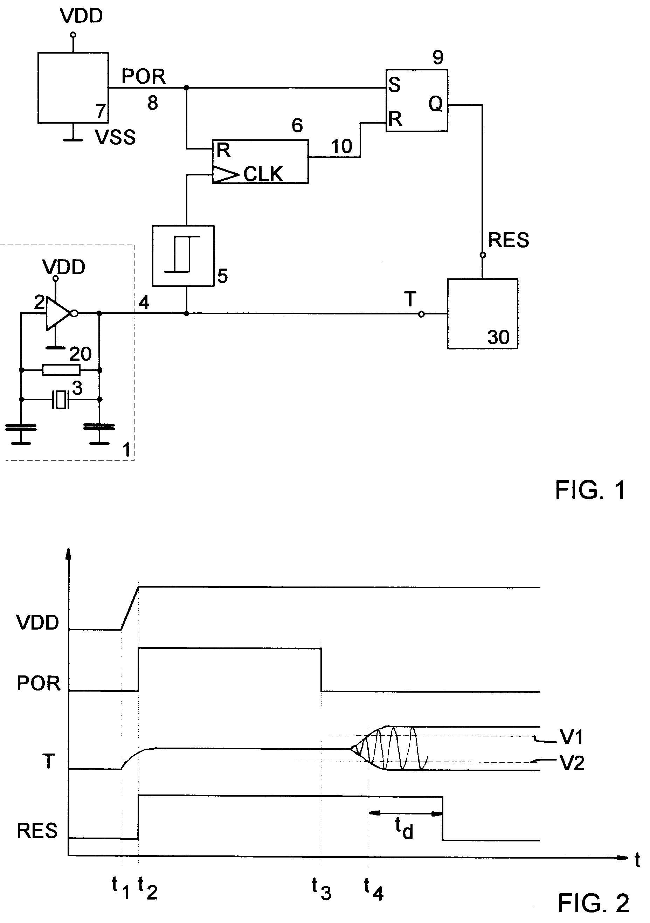

Die Schaltung der Figur 1 enthält als Taktgenerator einen Quarzoszillator 1. Im einzelnen weist der Quarzoszillator einen Verstärker 2 auf, der von den die Versorgungsspannung bildenden Versorgungspotentialen VDD, VSS gespeist wird. Ein- und Ausgänge des Inverterverstärkers 2 sind über einen Quarz 3 miteinander gekoppelt. Der Ausgang 4 des Quarzoszillators 1 ist mit einer als Schmitt-Trigger ausgeführten Pegelbewertungsschaltung 5 verbunden. Der Ausgang des Schmitt-Triggers 5 speist den Takteingang eines Zählers 6. Eine Einrichtung 7, die an die Versorgungsspannung VDD, VSS angeschlossen ist, erzeugt einen Impuls bei ansteigender Versorgungsspannung. Die Einrichtung 7 ist zweckmäßigerweise eine herkömmliche Schaltung zur Erzeugung eines Power-on-Reset-Signals (POR). Das Signal POR am Ausgang 8 der Einrichtung 7 wird sowohl dem Rücksetzeingang des Zählers 6 als auch einem Eingang, zum Beispiel dem Setzeingang, eines RS-Flip-Flops 9 zugeführt. Der Rücksetzeingang des Flip-Flops 9 ist mit einem Ausgang 10 des Zählers 6 verbunden. Ein Signal am Anschluß 10 wird dann erzeugt, wenn der Zähler 6 einen bestimmten Zählerstand erreicht hat, zum Beispiel einen Überlauf. Am Ausgang des Flip-Flops 9 ist das Freigabesignal RES abgreifbar. Zähler 6 und Flip-Flop 9 bilden die Verzögerungseinrichtung für das Signal POR. Die verzögerte Signalflanke des Signals RES gibt an, daß der Quarzoszillator 1 eingeschwungen ist und einen in Amplitude und Frequenz stabilen Ausgangstakt T liefert. Praktischerweise wird das Signal RES zur Einstellung eines vorbestimmten Anfangszustandes der vom Oszillator 1 mit dem Takt T zu versorgenden taktgesteuerten Schaltung 30 verwendet; mit der Deaktivierung des Signals RES nimmt diese Schaltung nunmehr ihren Betrieb auf.

Die Funktionsweise der in Figur 1 gezeigten Schaltung wird nun anhand des in Figur 2 dargestellten Signaldiagramms erläutert. Zum Zeitpunkt t₁ beginnt das positive Potential der Versorgungsspannung VDD zu steigen. Gleichzeitig fährt der Quarzoszillator 1 in seinen Arbeitspunkt, der im wesentlichen durch einen Rückkopplungswiderstand 20 im Eingangs/Ausgangssignalpfad des Inverterverstärkers 2 bestimmt wird. Wenn die Versorgungsspannung einen bestimmten Wert erreicht hat, wird das Power-on-Reset-Signal POR zum Zeitpunkt t₂ erzeugt. Entsprechend wird das Flip-Flop 9 und somit dessen Ausgangssignal RES gesetzt. Nach einer durch die Charakteristika der Schaltung 7 bestimmten Zeitdauer wird das Signal POR zum Zeitpunkt t₃ wieder inaktiv. Der Oszillator 1 ist jedoch noch nicht eingeschwungen. Am Ausgang 4 des Oszillators liegt noch kein gültiges Taktsignal T an. Stattdessen können dort Rauschimpulse auftreten. Das Signal RES ist jedoch weiterhin aktiv, so daß die vom Quarzoszillator 1 versorgten Schaltungseinheiten noch nicht vom Oszillatorausgangssignal T beeinflußt werden. Mit V1 und V2 sind die durch den Schmitt-Trigger 5 gebildeten Schwellwerte bezeichnet. Erst zum Zeitpunkt t₄, wenn die Oszillatoramplitude die Schwellwerte V1, V2 über- bzw. unterschreitet, wird am Ausgang des Schmitt-Triggers ein Taktsignal erzeugt, durch das der Zähler 6 getaktet wird. Der Zähler 6 war bisher durch das Signal POR auf seinen Nullzustand rückgesetzt. Nach Ablauf der durch den Überlauf des Zählers 6 festgelegten Verzögerungszeit t₆ wird das Flip-Flop 9 rückgesetzt, so daß dessen Ausgangssignal RES wieder deaktiviert wird.

Die beschriebene Schaltung wirkt also derart, daß die Deaktivierung des Power-on-Rücksetzsignals POR um die durch den Überlaufwert des Zählers 6 bestimmte Anzahl von Takten verzögert wird. Dadurch wird verhindert, daß bereits einzelne Störimpulse des vom Quarzoszillator 1 abgegebenen Signals zwischen den Zeitpunkten t₂ und t₄, insbesondere zwischen t₃ und t₄, zu einer Fehlfunktion der vom Takt T zu versorgenden Schaltung 30 führen. Es ist gewährleistet, daß der Rücksetzzustand der Schaltung 30 solange aktiv bleibt, bis die Amplitude des Oszillators 1 eine Mindestamplitude erreicht hat, so daß dadurch feststeht, daß die Sollfrequenz erreicht ist.

Für die Pegelbewertungseinrichtung 5 eignet sich neben dem in der Figur 1 dargestellten Schmitt-Trigger jede Schaltung, die eine Pegelbewertung des Ausgangssignals des Oszillators 4 in bezug auf mindestens zwei Pegel durchführt. Zweckmäßigerweise liegen die Pegel symmetrisch zum Arbeitspunkt des Oszillators 1. Der Schwellenvergleich kann beispielsweise auch durch zwei Komparatoren bewirkt werden, die ein Überschreiten der Referenzschwelle V1 und ein Unterschreiten der Referenzschwelle V2 feststellen und den Setz- bzw. Rücksetzeingang eines Flip-Flops ansteuern.

## Patentansprüche

1. Schaltungsanordnung zur Erzeugung eines Freigabesignals (RES) für eine taktsteuerbare Schaltung (30) enthaltend ein Mittel (7) zur Zuführung eines durch einen Anstieg der Versorgungsspannung (VSS, VDD) erzeugten Impulses (POR), einen von der Versorgungsspannung (VSS, VDD) gespeisten Taktgenerator (1), eine vom Taktgenerator (1) angesteuerte Pegelbewertungseinrichtung (5), einen Zähler (6), der von der Pegelbewertungseinrichtung (5) taktgesteuert wird und einen Impuls abgibt, wenn ein vorgegebener Zählerstand erreicht ist, und ein Speicherelement (9), das in einen ersten von zwei Zuständen durch den Impuls (POR) setzbar ist und in einen zweiten Zustand durch das vom Zähler (9) abgegebene Signal und an dessen Ausgang das Freigabesignal (RES) abgreifbar ist.

2. Schaltungsanordnung nach Anspruch 1,
**dadurch gekennzeichnet**, daß
durch die Pegelbewertungseinrichtung (5) ein Vergleich des vom Taktgenerator (1) abgegebenen Signals mit mindestens zwei Schwellwerten (V1, V2) durchgeführt wird.

3. Schaltungsanordnung nach Anspruch 2,
**dadurch gekennzeichnet,** daß
die Pegelbewertungseinrichtung (5) als ein Schmitt-Trigger (5) ausgeführt ist, der eingangsseitig mit dem Taktgenerator (1) verbunden ist und ausgangsseitig mit dem Zähler (9) verbunden ist.

4. Schaltungsanordnung nach einem der Ansprüche 1 bis 3,
**dadurch gekennzeichnet**, daß
ein Rücksetzeingang des Zählers (9) vom Impuls (POR) gesteuert wird.
